# EUROPÄISCHE PATENTSCHRIFT

(11) **EP 3 935 728 B1**
(45) Veröffentlichungstag und Bekanntmachung des Hinweises auf die Patenterteilung: **10.04.2024**
(21) Anmeldenummer: 20705887.6
(22) Anmeldetag: 14.02.2020
(51) Int. Cl.: H02P 23/14, G01R 1/20, H03M 3/00

(54) **ANTRIEB MIT VON EINEM WECHSELRICHTER SPEISBAREM ELEKTROMOTOR UND VERFAHREN ZUM BETREIBEN EINES ANTRIEBS**
DRIVE HAVING AN ELECTRIC MOTOR ABLE TO BE FED BY AN INVERTER, AND METHOD FOR OPERATING A DRIVE
ENTRAÎNEMENT COMPRENANT UN MOTEUR ÉLECTRIQUE ALIMENTÉ PAR UN ONDULEUR ET PROCÉDÉ DE FONCTIONNEMENT D'UN ENTRAÎNEMENT

(30) Priorität: 08.03.2019 DE 102019001584
(43) Veröffentlichungstag der Anmeldung: 12.01.2022
(73) Patentinhaber: SEW-EURODRIVE GmbH & Co. KG, 76646 Bruchsal (DE)
(72) Erfinder: KOLLAR, Hans Jürgen, 76646 Bruchsal (DE); MARAHRENS, Klaus, 76337 Waldbronn-Reichenbach (DE); STARK, Marcel, 74909 Meckesheim (DE)
(86) Internationale Anmeldenummer: PCT/EP2020/025070
(87) Internationale Veröffentlichungsnummer: WO 2020/182340

(56) Entgegenhaltungen:
- DE-A1-102010 032 296
- DE-A1-102013 212 444
- US-A1- 2014 300 346
- TEXAS INSTRUMENTS INCORPORATED: "Motor Control Current Shunt 1-Bit, 10MHz, 2nd-Order, Delta-Sigma Modulator", INTERNET CITATION, 1. Dezember 2002 (2002-12-01), Seiten 1-19, 1, XP002615723, Gefunden im Internet: URL:http://focus.ti.com/lit/ds/symlink/ads 1202.pdf [gefunden am 2010-12-17]

## Beschreibung

Die Erfindung betrifft einen Antrieb mit von einem Wechselrichter speisbarem Elektromotor und Verfahren zum Betreiben eines Antriebs.

Es ist allgemein bekannt, dass ein Elektromotor aus einem wechselspannungsseitigen Anschluss eines Wechselrichters speisbar ist.

Aus der DE 10 2014 115 881 A1 **ist** ein Verfahren zum Vergrößern eines Stromerfassungsbereichs in einem System mit einem mehrphasigen Motor bekannt.

Aus der DE 101 43 932 A1 ist eine Shunt-Widerstandsanordnung bekannt.

Aus der DE 10 2016 220 298 A1 ist ein Verfahren zur Ermittlung eines elektrischen Gesamtstroms durch eine mehrlagige Leiterplatte bekannt.

Aus der DE 10 2015 204 396 A1 ist ein Verfahren zujm Anfahren eines bürstenlosen Gleichstrommotors bekannt.

Aus der DE 10 2013 101 857 A1 ist ein Halbleitermodul mit Schaltelementen bekannt.

**Aus der** DE 10 2013 212444A1 ist als nächstliegender Stand der Technik eine Kühlstruktur für einen Shunt-Widerstand und eine Wechselrichtervorrichtung bekannt.

**Aus der** US 2014/300346 A1 **ist ein elektrischer Shunt-Stromsensor bekannt.**

**Aus der** DE 10 2010 032296 A1 **ist ein Verfahren zur Verarbeitung eines einen analog bestimmten Wert für Ausgangsstrom eines Umrichters darstellenden Messwertsignals bekannt.**

**Aus der XP002615723 ist eine Motorsteuerung mit Shuntwiderstand bekannt.**

Der Erfindung liegt daher die Aufgabe zugrunde, eine verbesserte Stromerfassung bei einem Wechselrichter auszubilden.

Erfindungsgemäß wird die Aufgabe bei dem Antrieb nach den in Anspruch 1 und bei dem Verfahren nach den in Anspruch 9 angegebenen Merkmalen gelöst.

Wichtige Merkmale der Erfindung bei dem Antrieb mit von einem Wechselrichter speisbarem Elektromotor sind,
dass der Elektromotor mittels Zuleitungen mit dem wechselspannnungsseitigen Anschluss des Wechselrichters verbunden ist,
insbesondere wobei eine jeweilige Zuleitung zu einem jeweiligen Motorphasenanschluss des dreiphasig oder mehrphasig ausgeführten Elektromotors geführt ist,
wobei Stromsensoren zur Erfassung des Stroms in einer der Zuleitungen parallelgeschaltet sind,
wobei jeder der Stromsensoren jeweils eine Leiterplatte aufweist, die jeweils mit einem jeweiligen als Shunt-Widerstand fungierenden Widerstand, insbesondere in SMD Technik, bestückt ist,
wobei jeweils ein erster Anschluss des Widerstands mit einem jeweiligen ersten Stromschienenteil elektrisch verbunden, insbesondere schraubverbunden, ist,
wobei jeweils ein zweiter Anschluss des Widerstands mit einem jeweiligen zweiten Stromschienenteil elektrisch verbunden, insbesondere schraubverbunden, ist,
wobei die ersten Stromschienenteile miteinander elektrisch verbunden sind und/oder einstückig miteinander ausgeführt sind,
wobei die zweiten Stromschienenteile miteinander elektrisch verbunden sind und/oder einstückig miteinander ausgeführt sind.

Von Vorteil ist dabei, dass auf Stromschienen geführte Starkströme mittels Shuntwiderständen erfassbar sind, da die Shuntwiderstände parallelgeschaltet sind und somit nur jeweils einen Teilstrom erfassen müssen. Dabei sind die Shuntwiderstände oberflächenmontierbar auf der Leiterplatte, also in SMD-Technik bestückt auf der Leiterplatte. Auf diese Weise ist eine kostengünstige hochpräzise Erfassung ermöglicht. Denn die an den Shuntwiderständen abfallenden Spannungen werden über einen AD-Wandler, insbesondere Delta-Sigma-Wandler, als digitaler Signalstrom des jeweiligen Stromsensors übertragen und der Gesamtstrom ohne wesentliche Totzeit oder Verzögerung, also möglichst zeitnah und/oder in Echtzeit, übertragen.

Bei einer vorteilhaften Ausgestaltung sind das erste und das zweite Stromschienenteil jeweils auf der vom Widerstand abgewandten Seite der Leiterplatte angeordnet. Von Vorteil ist dabei, dass die Leiterplatte einfach aufsetzbar ist auf die gegeneinander elektrisch isoliert angeordneten Stromschienenteile. Somit ist eine einfache Herstellung ermöglicht.

Bei einer vorteilhaften Ausgestaltung ist die Leiterplatte mit einer ersten Leiterbahn auf dem ersten Stromschienenteil aufgelegt und/oder lötverbunden,
die Leiterplatte mit einer zweiten Leiterbahn auf dem zweiten Stromschienenteil aufliegt und/oder lötverbunden ist. Von Vorteil ist dabei, dass die Leiterplatte direkt mit ihren Leiterbahnen mit den Stromschienenteilen lötverbindbar ist. Somit ist in kostengünstiger Weise die Lötverbindung zur elektrischen Verbindung und zum Halten der Leiterplatte verwendbar.

Bei einer vorteilhaften Ausgestaltung wird jeweils die am Widerstand abfallende Spannung einem jeweiligen Delta-Sigma-Wandler des jeweiligen Stromsensors zugeführt, wobei der jeweilige Delta-Sigma-Wandler an seinem Ausgang als Ausgangssignal einen digitalen, insbesondere 1-Bit-breiten, Datenstrom zur Verfügung steht,
insbesondere wobei das oder die Bauteile des Delta-Sigma-Wandlers des jeweiligen Stromsensors auf der Leiterplatte des jeweiligen Stromsensors angeordnet und/oder bestückt sind. Von Vorteil ist dabei, dass der erfasste Stromistwert digital verarbeitbar ist. Somit sind Einflüsse von Störquellen ausblendbar.

Erfindungsgemäß beträgt die Anzahl der Stromsensoren N, wobei N eine natürliche Zahl ist, welche größer als Eins ist,
wobei die N Ausgangssignale der Stromsensoren summiert werden und das Ergebnis als N-Bit-breiter Datenstrom einem Eingang, insbesondere N-bit-breiten Eingang, eines digitalen Modulators zugeführt werden,
insbesondere wobei der digitale Modulator als digital ausgeführter Tiefpass, insbesondere zweiter Ordnung, ausgeführt ist. Von Vorteil ist dabei, dass durch den digitalen Modulator der summierte tiefpassgefilterte Gesamtstrom zur Verfügung gestellt wird, insbesondere als ein 1-Bit-breites Datensignal an dessen Ausgang.

Bei einer alternativen Ausgestaltung gemäß der Erfindung Ausgestaltung beträgt die Anzahl der Stromsensoren N, wobei N eine natürliche Zahl ist, welche größer als Eins ist,
wobei die N Ausgangssignale der Stromsensoren einen N-Bit-breiten Datenstrom bilden, welcher einem Eingang, insbesondere N-bit-breiten Eingang, eines digitalen Modulators zugeführt werden,
insbesondere wobei jedes einzelne Ausgangssignal eine jeweilige Stelle, insbesondere also eine jeweilige Bit-Position, des N-Bit-breiten Datenstroms bildet,
insbesondere wobei der digitale Modulator als digital ausgeführter Tiefpass, insbesondere zweiter Ordnung, ausgeführt ist. Von Vorteil ist dabei, dass keine Totzeit durch die Summierung der Signale bewirkt wird. Durch den digitalen Modulator wird aber der summierte tiefpassgefilterte Gesamtstrom zur Verfügung gestellt, insbesondere als ein 1-Bit-breites Datensignal an dessen Ausgang.

Bei einer vorteilhaften Ausgestaltung weist der digitale Modulator zumindest einen Summierer auf, dem der N-Bit-breite Datenstrom zugeführt wird und dessen Ausgangssignal einem Integrator zugeführt wird,
wobei der digitale Modulator einen Quantisierer zur Verarbeitung des Ausgangssignals aufweist, dessen insbesondere 1-Bit breites Ausgangssignal einen ersten Wert, insbesondere HIGH aufweist, wenn das Eingangssignal des Quantisierers einen oberen Schwellwert überschreitet, und erst dann einen zweiten Wert, insbesondere LOW aufweist, wenn das Eingangssignal des Quantisierers einen unteren Schwellwert unterschreitet,
wobei das Ausgangssignal des Quantisierers nicht nur das Ausgangssignal des digitalen Modulators bildet, sondern auch einem Quantisierumsetzer zugeführt wird, dessen Ausgangssignal abhängig vom jeweils aktuellen Wert des Ausgangssignals des Quantisierers den oberen oder den unteren Schwellwert als N-Bit breites Datensignal ausgibt und dieses Datensignal dem Summierer zugeführt wird. Von Vorteil ist dabei, dass ein Tiefpassverhalten durch den Modulator bewirkt wird. Außerdem steht am Ausgang des Modulators der Summenstrom, also die Summe aus den von den einzelnen Stromsensoren erfassten Werten, digital als 1-Bit-breites Datensignal zur Verfügung. Der obere und der untere Schwellwert sind geeignet gewählt.

Bei einer vorteilhaften Ausgestaltung wird der N-Bit-breite Datenstrom einem Summierer zugeführt, dessen Ausgangssignal einem ersten Integrator zugeführt wird,
wobei das Ausgangssignal des ersten Integrators einem zweiten Summierer zugeführt wird, dessen Ausgangssignal einem zweiten Integrator zugeführt wird,
wobei das Ausgangssignal des zweiten Integrators einem Quantisierer zugeführt wird, dessen insbesondere 1-Bit breites Ausgangssignal einen ersten Wert, insbesondere HIGH aufweist, wenn das Ausgangssignal des zweiten Integrators einen oberen Schwellwert überschreitet, und erst dann einen zweiten Wert, insbesondere LOW aufweist, wenn das Ausgangssignal des zweiten Integrators, also das Eingangssignal des Quantisierers, einen unteren Schwellwert unterschreitet,
wobei das Ausgangssignal des Quantisierers nicht nur das Ausgangssignal des digitalen Modulators bildet, sondern auch einem Quantisierumsetzer zugeführt wird, dessen Ausgangssignal abhängig vom jeweils aktuellen Wert des Ausgangssignals des Quantisierers den oberen oder den unteren Schwellwert als N-Bit breites Datensignal ausgibt und dieses Datensignal dem ersten und auch dem zweiten Summierer zugeführt wird,
insbesondere wobei der erste Summierer als Ausgangssignal die Summe aus dem Datensignal und dem N-Bit-breiten Datenstrom bildet und wobei der zweite Summierer als Ausgangssignal die Summe aus dem Datensignal und dem Ausgangssignal des ersten Integrators bildet. Von Vorteil ist dabei, dass ein Tiefpassverhalten zweiter Ordnung durch den Modulator bewirkt wird. Außerdem steht am Ausgang des Modulators der Summenstrom, also die Summe aus den von den einzelnen Stromsensoren erfassten Werten, digital als 1-Bit-breites Datensignal zur Verfügung. Der obere und der untere Schwellwert sind geeignet gewählt.

Bevorzugt ist die Anzahl der Stromsensoren gleich Zwei.

Bei einer vorteilhaften Ausgestaltung sind die Summierer, das Summiermittel, die Integratoren, der Quantisierer und der Quantisierumsetzer, die Delta-Sigma-Wandler und/oder die Verarbeitungseinheit in einem einzigen FPGA implementiert. Von Vorteil ist dabei, dass mit geringem Logik-Ressourcen kostengünstig die Signale sehr schnell verarbeitbar sind.

Bei einer vorteilhaften Ausgestaltung werden die Signale zweier, parallel geschalteter Stromsensoren überwacht auf Überschreiten eines zulässigen Maßes an Abweichung. Von Vorteil ist dabei, dass die Stromaufteilung auf die beiden parallel geschalteten Pfade überwachbar sind. Beispielsweise ist somit das Lösen einer Schraubverbindung zwischen Stromsensor und Leiterplatte erkennbar.

Wichtige Merkmale bei dem Verfahren zum Betreiben eines Antriebs sind, dass der Strom in einer Motorphasenzuleitung eines Elektromotors des Antriebs erfasst wird, indem eine Anzahl N von Stromsensoren parallel vorgesehen, insbesondere geschaltet, sind, wobei die N digital dargestellten, 1-Bit-breiten Signale der Stromsensoren als N-Bit-breiter Datenstrom dem Eingang, insbesondere N-bit-breiten Eingang, eines digitalen Modulators des Antriebs zugeführt werden,
insbesondere wobei jedes einzelne Ausgangssignal des jeweiligen Stromsensors eine jeweilige Stelle, insbesondere also eine jeweilige Bit-Position, des N-Bit-breiten Datenstroms bildet,
insbesondere wobei der digitale Modulator ein Tiefpassverhalten, insbesondere zweiter Ordnung, aufweist,
insbesondere wobei das Ausgangssignal des digitalen Modulators ein 1-Bit-breiter Datenstrom ist.

Von Vorteil ist dabei, dass eine schnelle Ermittelung des Gesamtstroms in der Motorphasenleitung als digitaler Wert ausführbar ist.

Bei einer vorteilhaften Ausgestaltung weisen die Stromsensoren jeweils einen Shuntwiderstand auf und es werden die am jeweiligen Shuntwiderstand des jeweiligen Stromsensors abfallende Spannungen erfasst und von einem Delta-Sigma-Wandler in das digitale, 1-Bit-breite Signal des jeweiligen Stromsensors umgewandelt. Von Vorteil ist dabei, dass eine digitale Signalverarbeitung und Ermittlung des Gesamtstroms in der Motorphase in einfacher Weise erfolgt.

Bei einer vorteilhaften Ausgestaltung wird das Ausgangssignal des digitalen Modulators als Stromistwert zum Regeln des Elektromotors, insbesondere des Motorstroms des Elektromotors, verwendet. Von Vorteil ist dabei, dass die Drehzahl oder das Drehmoment des Elektromotors auf einen Sollwert hingeregelt wird, indem der erfasste Stromistwert auf einen Sollwert hin geregelt wird. Da der Stromistwert nur geringfügig verzögert als digitales Ausgangssignal des digitalen Modulators zur Verfügung steht, ist ein hoch dynamisches und somit auch verbessertes Regeln ermöglicht. Ein zeitverzögertes, totzeitbehaftetes zur Verfügung gestelltes Ergebnis größer einer Regelperiode würde zu einer Verschlechterung bei den Regeleigenschaften des Wechselrichters führen. Die geringfügige Verzögerung ist hierbei sogar deterministisch, nämlich der Gruppenlaufzeit des digitalen Modulators entsprechend. Somit lässt sich die Wirkung der Totzeit mittels geeigneter mathematischer Modelle oder Beobachterstrukturen, wie beispielsweise Luenberger-Beobachter, korrigieren

Bei einer vorteilhaften Ausgestaltung wird dem N-Bit-breiten Datenstrom das Ausgangssignal eines Quantisierumsetzers aufaddiert und das so entstandene Summensignal wird integriert und das Ergebnis dieser Integration wird einem Quantisierer zugeführt, dessen, insbesondere 1-Bit breites, Ausgangssignal einen ersten Wert, insbesondere HIGH aufweist, wenn das Eingangssignal des Quantisierers einen oberen Schwellwert überschreitet, und erst dann einen zweiten Wert, insbesondere LOW aufweist, wenn das Eingangssignal des Quantisierers einen unteren Schwellwert unterschreitet,
wobei das Ausgangssignal des Quantisierers nicht nur das Ausgangssignal des digitalen Modulators bildet, sondern auch dem Quantisierumsetzer zugeführt wird, dessen Ausgangssignal abhängig vom jeweils aktuellen Wert des Ausgangssignals des Quantisierers den oberen oder den unteren Schwellwert als N-Bit breites Datensignal ausgibt, insbesondere und dieses Datensignal dem Summierer zugeführt wird. Von Vorteil ist dabei, dass tiefpassgefilterter Stromwert schnell, also ohne Totzeit, zur Verfügung stellbar ist.

Bei einer vorteilhaften Ausgestaltung wird dem N-Bit-breiten Datenstrom das Ausgangssignal eines Quantisierumsetzers aufaddiert und das so entstandene Summensignal integriert und dem Ergebnis dieser Integration ebenfalls das Ausgangssignal eines Quantisierumsetzers aufaddiert wird und das so entstandene Summensignal integriert wird und das Ergebnis dieser Integration einem Quantisierer zugeführt wird, dessen, insbesondere 1-Bit breites, Ausgangssignal einen ersten Wert, insbesondere HIGH aufweist, wenn das Eingangssignal des Quantisierers einen oberen Schwellwert überschreitet, und erst dann einen zweiten Wert, insbesondere LOW aufweist, wenn das Eingangssignal des Quantisierers einen unteren Schwellwert unterschreitet,
wobei das Ausgangssignal des Quantisierers nicht nur das Ausgangssignal des digitalen Modulators bildet, sondern auch dem Quantisierumsetzer zugeführt wird, dessen Ausgangssignal abhängig vom jeweils aktuellen Wert des Ausgangssignals des Quantisierers den oberen oder den unteren Schwellwert als N-Bit breites Datensignal ausgibt, insbesondere und dieses Datensignal dem Summierer zugeführt wird. Von Vorteil ist dabei, dass 2. Ordnung tiefpassgefilterter Stromwert schnell, also ohne Totzeit, zur Verfügung stellbar ist.

Erfindungsgemäß sind also bei dem Umrichter mit Stromerfassung mehrere Stromsensoren parallel zwischen Stromschienen angeordnet. Jeder Stromsensor weist einen SMDmontierten Shunt-Widerstand auf. Die Signale der Stromsensoren werden als paralleler Datenstrom zusammengefasst und einem digitalen Modulator zugeführt oder alternativ werden die Signale der Stromsensoren addiert und einem digitalen Modulator zugeführt. Der Modulator hat ein Tiefpassverhalten und stellt am Ausgang des Summenstrom einphasen digital zur Verfügung.

Weitere Vorteile ergeben sich aus den Unteransprüchen.

Die Erfindung wird nun anhand von schematischen Abbildungen näher erläutert:
In der Figur 1 ist ein von einem erfindungsgemäßen Wechselrichter gespeister Elektromotor M dargestellt, wobei die Erfassung der Phasenströme in den Motorzuleitungen schematisch ausgeführt ist.
In der Figur 2 ist im Unterschied zur Figur 1 die Erfassung der Phasenströme näher dargestellt, wobei die galvanische getrennte Weiterleitung der Sensorsignale gezeigt ist.

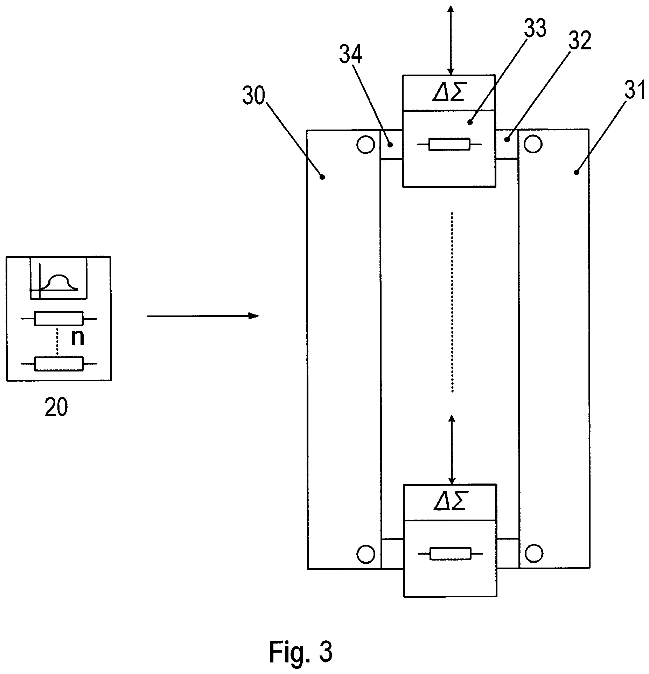

In Figur 3 die Erfassung des Stroms in einer jeweiligen Zuleitung des Elektromotors M als Parallelschaltung von Stromsensoranordnungen dargestellt.
In der Figur 4 ist eine erste Bestimmung des Gesamtstroms in der Zuleitung durch Summierung von Tiefpass-gefilterten Sensorsignalen dargestellt.
In der Figur 5 ist als Alternative zur Figur 4 Tiefpass-Filterung der summierten Sensorsignale dargestellt.
In der Figur 6 ist die Summierung aus Figur 5 näher dargestellt, wobei ein digitaler Modulator 60 verwendet ist.
In der Figur 7 ist der digitale Modulator 60 näher dargestellt.

Wie in den Figuren dargestellt, weist der erfindungsgemäße Antrieb einen von einem Wechselrichter gespeisten Elektromotor M auf.

Der Wechselrichter 1 weist eine Parallelschaltung von Reihenschaltungen auf, wobei jede der Reihenschaltungen zwei in Reihe geschaltete steuerbare Halbleiterschalter aufweist, an deren Verbindungsknoten jeweils eine Zuleitung des Elektromotors M elektrisch verbunden ist.

Der Elektromotor M ist als Drehstrommotor ausgeführt.

Die Parallelschaltung ist aus dem gleichspannungsseitigen Anschluss des Wechselrichters 1 versorgt. Die drei Verbindungsknoten der Reihenschaltungen fungieren als wechselspannungsseitiger Anschluss des Wechselrichters 1.

Jedem der steuerbaren Halbleiterschalter ist jeweils eine Freilaufdiode parallel zugeschaltet.

Im generatorischen Betrieb des Elektromotors M fungieren die Freilaufdioden somit als Gleichrichter und es wird die vom Elektromotor M als Drehspannung und Drehstrom gelieferte elektrische Leistung am gleichspannungsseitigen Anschluss des Wechselrichters bereitgestellt.

Die Halbleiter des Wechselrichters werden von pulsweitenmodulierten Ansteuersignalen angesteuert, die von einer Signalelektronik 2 des Wechselrichters erzeugt werden.

Somit ist im motorischen Betrieb des Elektromotors diesem am wechselspannungsseitigen Anschluss des Wechselrichters eine Drehspannung über Zuleitungen dem Elektromotor bereitstellbar.

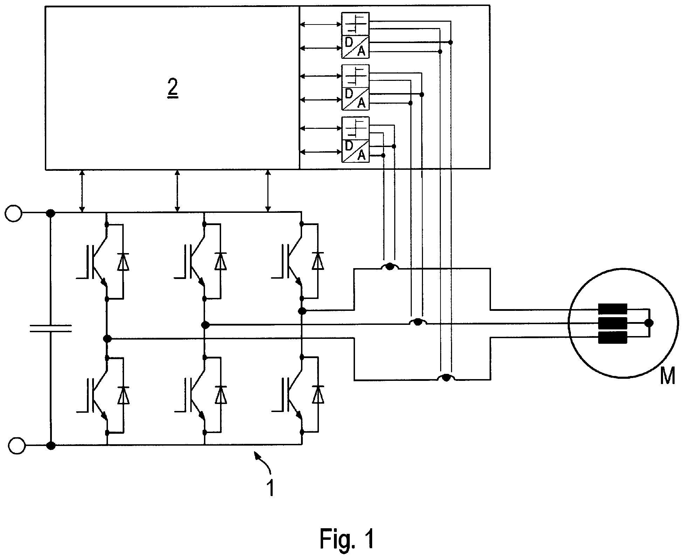

Die in den Zuleitungen fließenden Ströme werden erfasst. In Figur 1 ist hierzu in jeder der drei Zuleitungen symbolisch eine Stromerfassung dargestellt.

Einerseits wird der erfasste Strom, also das analoge Sensorsignal eines Mittels zur Stromerfassung, in ein digitales Signal gewandelt und von der Signalelektronik 2 weiterverarbeitet. Andererseits wird das analogen Sensorsignal auf Überschreiten eines Schwellwertes überwacht, weil die Wandlung in das digitale Signal Rechenzeit benötigt und somit eine digitale Überwachung eine größere Reaktionszeit verursacht. Nach Überschreiten des Schwellwerts wird ein Fehlerzustand weitergemeldet oder angezeigt und/oder ein sicherer Zustand, wie beispielsweise Abschalten des Antriebs, eingeleitet. Im einfachsten Fall wird hierzu ein STO-Signal herausgegeben.

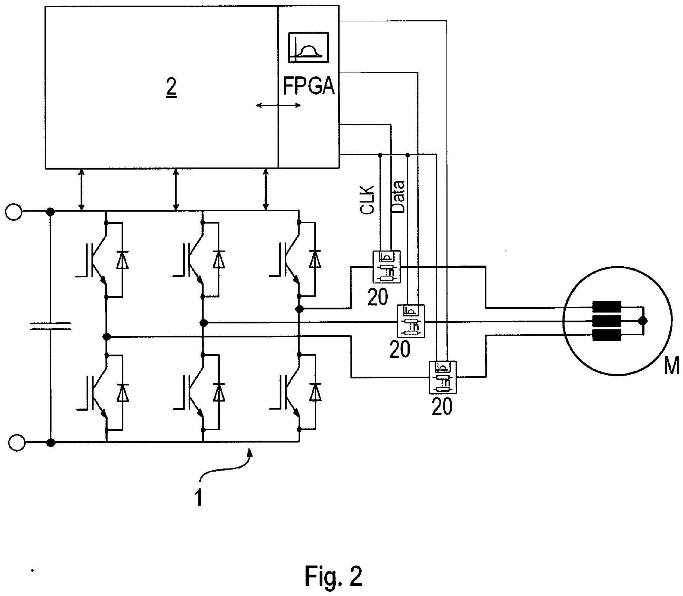

Wie in Figur 2 näher ausgeführt, wird das Sensorsignal galvanisch getrennt, insbesondere mittels eines Optokopplers, an die Signalelektronik 2 übertragen.

Vorzugsweise werden der hohen Ströme wegen als Zuleitungen zumindest teilweise Stromschienen verwendet.

Die Erfassung des Starkstroms in der jeweiligen Zuleitung wird aber unter Verwendung von Shunt-Widerständen einfach und kostengünstig ausgeführt.

Hierzu werden zwei oder mehr Stromsensoren 20 parallelgeschaltet.

Jeder der Stromsensoren 20 weist eine Leiterplatte 33 auf, welche mit einem Shunt-Widerstand bestückt ist, dessen erster Anschluss auf einem Stromschienenteil 32 lötverbunden ist und dessen zweiter Anschluss auf einem davon elektrisch isoliert angeordneten Stromschienenteil 34 schraubverbunden ist.

Zwischen den beiden Stromschienenteilen 32 und 34 ist nur eine elektrisch isolierende Schicht angeordnet.

Die Leiterplatte ist mit ihrer von dem Shunt-Widerstand abgewandten Seite auf die beiden Stromschienenteile 32 und 34 aufgesetzt und lötverbunden.

Der Shunt-Widerstand ist vorzugsweise mittels SMD-Technik auf der Leiterplatte angeordnet.

Auf der Leiterplatte 33 sind auch weitere elektronische Bauelemente bestückt zur Bildung einer elektronischen Schaltung, welche ein Mittel zur Erfassung der am Shunt-Widerstand abfallenden Spannung aufweist sowie einen Delta-Sigma-Wandler, dessen 1-bit-breites digitales Ausgangssignal mittels eines ebenfalls auf der Leiterplatte 33 bestückten Optokopplers galvanisch getrennt übertragen wird an eine Auswerteeinheit der Signalelektronik 2.

Das erste Stromschienenteil 32 jedes der Stromsensoren 20 ist mittels einer ersten Stromschiene 31 elektrisch verbunden.

Das zweite Stromschienenteil 34 jedes der Stromsensoren 20 ist mittels einer zweiten Stromschiene 30 elektrisch verbunden.

Auf diese Weise sind die Stromsensoren 20 parallelgeschaltet.

Somit ist die Zuleitung jeder Motorphase über eine solche Parallelschaltung von Stromsensoren 20 führbar und daher eine Erfassung des jeweiligen Motorphasenstroms einfach und kostengünstig ausführbar.

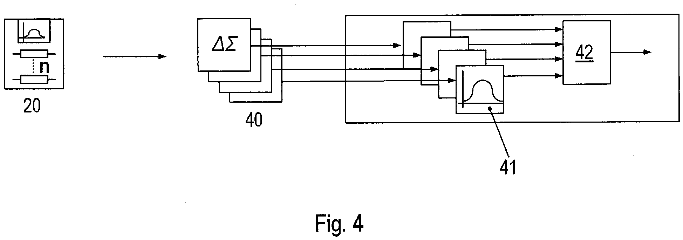

Zur Summierung der von den Stromsensoren 20 erfassten Stromwerte wäre es möglich, wie in Figur 4 dargestellt, die jeweiligen 1-bit breiten digitalen Signalströme der einzelnen Stromsensoren 20 jeweils, insbesondere deren jeweiligem Delta-Sigma-Wandler, zu filtern, insbesondere mittels eines jeweiligen digital ausgeführten Tiefpasses 41, und danach mittels einer Verarbeitungseinheit 42 zu summieren. Dabei entsteht jedoch der Nachteil, dass das summierte Signal erst zeitverzögert zur Verfügung steht.

Bei dieser Ausführung würde der mittlere Pegel des Summensignals die Summe der ursprünglichen Signale repräsentieren. Dieser Wert würde dann einem digital ausgeführten Tiefpass zugeführt werden, der den entsprechenden mittleren Pegel des summierten Eingangssignals wieder in einen 1-Bit Datenstrom moduliert. Dieser 1-Bitstrom würde diesen summierten mittleren Pegel am Eingang repräsentieren. Der Modulator würde dabei auch als Konverter von einem N-Bit-Signal zu einem Ein-Bit-Signal arbeiten.

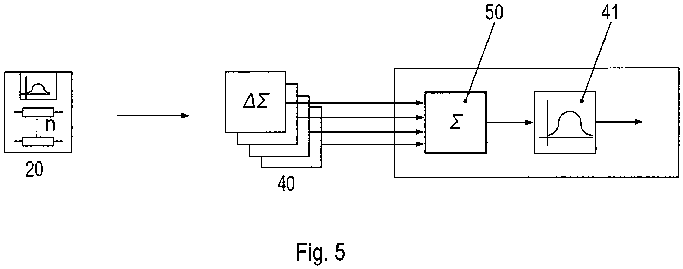

In anderer erfindungsgemäßer Ausführung wird gemäß Figur 5 zuerst die Summierung mittels eines Summiermittels 50 und danach die Filterung, insbesondere mittels eines Tiefpass 41 ausgeführt.

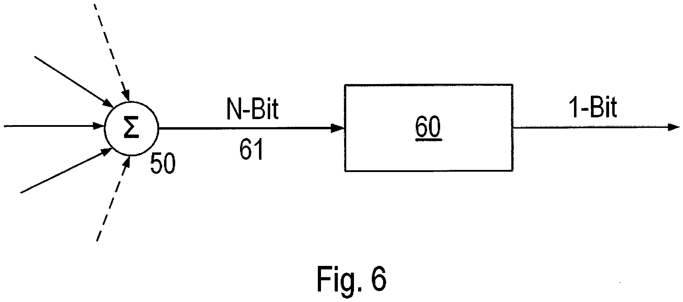

Hierzu wird das Summiermittel 50 speziell ausgeführt. Denn gemäß der in Figur 6 gezeigten schematischen Darstellung werden die 1-bit-breiten digitalen Signalströme zu einem N-bit breiten digitalen Datenstrom 61 zusammengefasst, wobei jeder der Signalströme einem Bit, also einer Stelle des jeweiligen N-bit breiten Datenworts, des Datenstroms 61 entspricht.

Die Anzahl der vom Summiermittel 50 zu summierenden Signalströme beträgt N und entspricht somit der Anzahl der zur Erfassung des Stromes einer jeweiligen Motorphase eingesetzten Stromsensoren 20.

Der N-bit breite Datenstrom 61 wird einem digitalen Modulator 60 zugeführt, dessen 1-bit breites digitales Ausgangssignal dann den summierten und gefilterten Wert des Stroms darstellt, welcher von der Signalelektronik 2 zur Drehzahlregelung oder zur Drehmomentregelung verwendet wird.

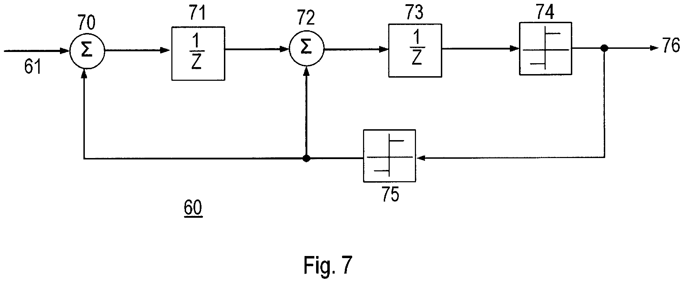

Wie in Figur 7 dargestellt, ist der digitale Modulator 60 als digitales Tiefpassfilter zweiter Ordnung aufgebaut. Dabei wird der N-Bit-breite Datenstrom 61 dem Summierer 70 zugeleitet, dessen Ausgangssignal einem ersten Integrator 71 zugeführt wird. Das Ausgangssignal wird einem Summierer 72 zugeleitet, dessen Ausgangssignal einem zweiten Integrator 73 zugeleitet wird, dessen Ausgangssignal einem Quantisierer 74 zugeleitet wird, welcher als Ausgangssignal einen HIGH oder LOW Zustand ausgibt, also 1 oder 0. Wenn das Ausgangssignal des zweiten Integrators 73 unterhalb eines unteren Schwellwertes liegt, wird eine 0 als Ausgangssignal 76 des Quantisierers 74 ausgegeben. Wenn jedoch das Ausgangssignal des zweiten Integrators 73 einen oberen Schwellwert übersteigt, wird eine 1 als Ausgangssignal 76 des Quantisierers 74 ausgegeben. Erst nach nachfolgendem Unterschreiten des unteren Schwellwertes wird wieder eine 0 ausgegeben als Ausgangssignal 76.

Das Ausgangssignal 76 des Quantisierer 74 ist 1-bit breit und wird einem Quantisierumsetzer 75 zugeführt, der abhängig vom Wert des in ihn eingehenden Ausgangssignals 76 entweder den unteren oder den oberen Schwellwert ausgibt. Beispielsweise wird der untere Schwellwert ausgegeben, wenn das Ausgangssignal 76 den Wert 1 aufweist und ansonsten der obere Schwellwert.

Dieses somit N-bit breite Ausgangssignal des Quantisierumsetzers 75 wird dem Summierer 70 und auch dem Summierer 72 zugeführt.

Der Summierer 70 summiert also den N-bit breiten Datenstrom 61 und das Ausgangssignal des Quantisierumsetzers 75.

Der Summierer 72 summiert also das N-bit breite Ausgangssignal des ersten Integrators 71 und das Ausgangssignal des Quantisierumsetzers 75.

Der N-bit breite Datenstrom ist in Figur 6 und Figur 7 jeweils mit einem dickeren Strich als der 1-bit breite Datenstrom dargestellt.

Auf diese Weise sind für die Tiefpassfilterung zweiter Ordnung nur zwei Taktsignal-Schritte notwendig, da nur der erste und zweite Integrator (71, 73) eine merkliche zeitliche Verzögerung bewirken.

Bei weiteren erfindungsgemäßen Ausführungsbeispielen wird im Rückkopplungspfad nach Figur 7 die bei der Zusammenführung der 1-Bit-Signale der Stromsensoren zu einem N-Bit-Signal bewirkte unterschiedliche Gewichtung zurückgeschoben.

Der erfindungsgemäß in allen drei Motorphasenleitungen mit den jeweiligen Stromsensoren 20 erfasste Stromistvektor wird zur Regelung des Elektromotors verwendet. Hierbei wird der Stromistvektor wird auf einen Stromsollvektor hingeregelt, indem der Wechselrichter eine entsprechend geeignete Spannung dem Elektromotor bereitstellt.

Bei weiteren erfindungsgemäßen Ausführungsbeispielen wird aus dem Stromistvektor und der erfassten Motorspannung ein Modellwert für Drehmoment bestimmt und eine derartige Spannung am wechselspannungsseitigen Anschluss des Wechselrichters gestellt, dass der Modellwert auf einen vorgegebenen Sollwert hingeregelt wird und auch die Drehzahl des Motors auf einen Sollwert hingeregelt wird. Durch die verschwindend geringe Totzeit bei der erfindungsgemäßen Stromerfassung ist ein sehr dynamisches Regeln ausführbar.

Bei weiteren erfindungsgemäßen Ausführungsbeispielen wird der digitale Modulator 60 als Tiefpass einer anderen Ordnung als 2. Ordnung ausgeführt, insbesondere als Tiefpass 1. Ordner, so dass eine noch weiter verringerte Totzeit bewirkt ist.

### Bezugszeichenliste

1 Wechselrichter
2 Signalelektronik
20 Stromsensor
30 zweite Stromschiene
31 erste Stromschiene
32 erster Stromschienenteil
33 Leiterplatte
34 zweiter Stromschienenteil
40 Delta-Sigma-Wandler
41 Tiefpassfilter
42 Verarbeitungseinheit
50 Summiermittel
60 digitaler Modulator
70 Summierer
71 erster Integrator
72 Summierer
73 zweiter Integrator
74 Quantisierer
75 Quantisierumsetzer
76 Ausgangssignal
M Elektromotor

## Patentansprüche

1. Antrieb mit von einem Wechselrichter (1) speisbarem Elektromotor,
wobei der Elektromotor mittels Zuleitungen mit dem wechselspannnungsseitigen Anschluss des Wechselrichters (1) verbunden ist,
insbesondere wobei eine jeweilige Zuleitung zu einem jeweiligen Motorphasenanschluss des dreiphasig oder mehrphasig ausgeführten Elektromotors geführt ist,
wobei Stromsensoren (20) zur Erfassung des Stroms in einer der Zuleitungen parallelgeschaltet sind,
**wobei** jeder der Stromsensoren (20) jeweils eine Leiterplatte (33) aufweist, die jeweils mit einem jeweiligen als Shunt-Widerstand fungierenden Widerstand, insbesondere in SMD Technik, bestückt ist,
wobei jeweils ein erster Anschluss des Widerstands mit einem jeweiligen ersten Stromschienenteil (32) elektrisch verbunden, insbesondere schraubverbunden, ist,
wobei jeweils ein zweiter Anschluss des Widerstands mit einem jeweiligen zweiten Stromschienenteil (34) elektrisch verbunden, insbesondere schraubverbunden, ist,
wobei die ersten Stromschienenteile (32) miteinander elektrisch verbunden sind und/oder einstückig miteinander ausgeführt sind,
wobei die zweiten Stromschienenteile (34) miteinander elektrisch verbunden sind und/oder einstückig miteinander ausgeführt sind,
wobei
- die Anzahl der Stromsensoren (20) N beträgt, wobei N eine natürliche Zahl ist, welche größer als Eins ist,
**dadurch gekennzeichnet, dass** die N Ausgangssignale der Stromsensoren (20) mittels eines Summiermittels (50) addiert werden und das Ergebnis dieser Addition einen N-Bit-breiten Datenstrom bildet, welcher einem Eingang, insbesondere N-bit-breiten Eingang, eines digitalen Modulators zugeführt werden, insbesondere wobei der digitale Modulator (60) als digital ausgeführter Tiefpass, insbesondere zweiter Ordnung, ausgeführt ist,
oder dass
die N Ausgangssignale der Stromsensoren (20) einen N-Bit-breiten Datenstrom bilden, welcher einem Eingang, insbesondere N-bit-breiten Eingang, eines digitalen Modulators zugeführt werden,
insbesondere wobei jedes einzelne Ausgangssignal eine jeweilige Stelle, insbesondere also eine jeweilige Bit-Position, des N-Bit-breiten Datenstroms bildet,
insbesondere wobei der digitale Modulator (60) als digital ausgeführter Tiefpass, insbesondere zweiter Ordnung, ausgeführt ist.

2. Antrieb nach Anspruch 1,
**dadurch gekennzeichnet, dass**
das erste und das zweite Stromschienenteil (32, 34) jeweils auf der vom Widerstand abgewandten Seite der Leiterplatte (33) angeordnet sind.

3. Antrieb nach einem der vorangegangenen Ansprüche,
**dadurch gekennzeichnet, dass**
die Leiterplatte (33) mit einer ersten Leiterbahn auf dem ersten Stromschienenteil (32) aufliegt und/oder lötverbunden ist,
die Leiterplatte (33) mit einer zweiten Leiterbahn auf dem zweiten Stromschienenteil (34) aufliegt und/oder lötverbunden ist.

4. Antrieb nach einem der vorangegangenen Ansprüche,
**dadurch gekennzeichnet, dass**
jeweils die am Widerstand abfallende Spannung einem jeweiligen Delta-Sigma-Wandler (40) des jeweiligen Stromsensors (20) zugeführt wird, wobei der jeweilige Delta-Sigma-Wandler (40) an seinem Ausgang als Ausgangssignal einen digitalen, insbesondere 1-Bit-breiten, Datenstrom zur Verfügung steht,
insbesondere wobei das oder die Bauteile des Delta-Sigma-Wandlers (40) des jeweiligen Stromsensors (20) auf der Leiterplatte (33) des jeweiligen Stromsensors (20) angeordnet und/oder bestückt sind.

5. Antrieb nach einem der vorangegangenen Ansprüche,
**dadurch gekennzeichnet, dass**
der digitale Modulator (60) zumindest einen Summierer (70, 72) aufweist, dem der N-Bit-breite Datenstrom zugeführt wird und dessen Ausgangssignal einem Integrator (71) zugeführt wird,
wobei der digitale Modulator (60) einen Quantisierer (74) zur Verarbeitung des Ausgangssignals des Integrators (71) aufweist, dessen insbesondere 1-Bit breites Ausgangssignal einen ersten Wert, insbesondere HIGH aufweist, wenn das Eingangssignal des Quantisierers (74) einen oberen Schwellwert überschreitet, und erst dann einen zweiten Wert, insbesondere LOW aufweist, wenn das Eingangssignal des Quantisierers (74) einen unteren Schwellwert unterschreitet,
wobei das Ausgangssignal des Quantisierers (74) nicht nur das Ausgangssignal (76) des digitalen Modulators bildet, sondern auch einem Quantisierumsetzer zugeführt wird, dessen Ausgangssignal abhängig vom jeweils aktuellen Wert des Ausgangssignals des Quantisierers (74) den oberen oder den unteren Schwellwert als N-Bit breites Datensignal ausgibt und dieses Datensignal dem Summierer (70, 72) zugeführt wird.

6. Antrieb nach einem der vorangegangenen Ansprüche,
**dadurch gekennzeichnet, dass**
der N-Bit-breite Datenstrom einem Summierer (70, 72) zugeführt wird, dessen Ausgangssignal einem ersten Integrator (71) zugeführt wird,
wobei das Ausgangssignal des ersten Integrators (71) einem zweiten Summierer (70, 72) zugeführt wird, dessen Ausgangssignal einem zweiten Integrator (73) zugeführt wird,
wobei das Ausgangssignal des zweiten Integrators (73) einem Quantisierer (74) zugeführt wird, dessen insbesondere 1-Bit breites Ausgangssignal einen ersten Wert, insbesondere HIGH aufweist, wenn das Ausgangssignal des zweiten Integrators (73) einen oberen Schwellwert überschreitet, und erst dann einen zweiten Wert, insbesondere LOW aufweist, wenn das Ausgangssignal des zweiten Integrators (73), also das Eingangssignal des Quantisierers (74), einen unteren Schwellwert unterschreitet,
wobei das Ausgangssignal des Quantisierers (74) nicht nur das Ausgangssignal (76) des digitalen Modulators bildet, sondern auch einem Quantisierumsetzer zugeführt wird, dessen Ausgangssignal abhängig vom jeweils aktuellen Wert des Ausgangssignals des Quantisierers (74) den oberen oder den unteren Schwellwert als N-Bit breites Datensignal ausgibt und dieses Datensignal dem ersten und auch dem zweiten Summierer (70, 72) zugeführt wird,
insbesondere wobei der erste Summierer (70, 72) als Ausgangssignal die Summe aus dem Datensignal und dem N-Bit-breiten Datenstrom bildet und wobei der zweite Summierer (70, 72) als Ausgangssignal die Summe aus dem Datensignal und dem Ausgangssignal des ersten Integrators (71) bildet.

7. Antrieb nach einem der vorangegangenen Ansprüche,
**dadurch gekennzeichnet, dass**
die Summierer (70, 72), das Summiermittel (50), die Integratoren (71, 73), der Quantisierer und der Quantisierumsetzer, die Delta-Sigma-Wandler (40) und/oder die Verarbeitungseinheit (42) in einem einzigen FPGA implementiert sind.

8. Antrieb nach einem der vorangegangenen Ansprüche,
**dadurch gekennzeichnet, dass**
die Signale zweier, parallel geschalteter Stromsensoren (20) überwacht werden auf Überschreiten eines zulässigen Maßes an Abweichung.

9. Verfahren zum Betreiben eines Antriebs **nach einem der vorangegangenen Ansprüche,**
wobei der Strom in einer Motorphasenzuleitung eines Elektromotors des Antriebs erfasst wird, indem eine Anzahl N von Stromsensoren (20) parallel vorgesehen, insbesondere geschaltet, sind,
**dadurch gekennzeichnet, dass**
- **entweder** die N digital dargestellten, 1-Bit-breiten Signale der Stromsensoren (20) als N-Bit-breiter Datenstrom dem Eingang, insbesondere N-bit-breiten Eingang, eines digitalen Modulators des Antriebs zugeführt werden,
insbesondere wobei jedes einzelne Ausgangssignal des jeweiligen Stromsensors (20) eine jeweilige Stelle, insbesondere also eine jeweilige Bit-Position, des N-Bit-breiten Datenstroms bildet,
- **oder** die N digital dargestellten, 1-Bit-breiten Signale der Stromsensoren (20) addiert werden und das Ergebnis der Addition als N-Bit-breiter Datenstrom dem Eingang, insbesondere N-bit-breiten Eingang, eines digitalen Modulators des Antriebs zugeführt wird,
insbesondere wobei der digitale Modulator (60) ein Tiefpassverhalten, insbesondere zweiter Ordnung, aufweist,
insbesondere wobei das Ausgangssignal (76) des digitalen Modulators ein 1-Bit-breiter Datenstrom ist.

10. Verfahren nach Anspruch 9, **dadurch gekennzeichnet, dass**
die Stromsensoren (20) jeweils einen Shuntwiderstand aufweisen und die am Shuntwiderstand abfallende Spannung erfasst und von einem Delta-Sigma-Wandler (40) in das digitale, 1-Bit-breite Signal des jeweiligen Stromsensors (20) umgewandelt werden.

11. Verfahren nach einem der Ansprüche 9 oder 10, **dadurch gekennzeichnet, dass**
das Ausgangssignal (76) des digitalen Modulators als Stromistwert zum Regeln des Elektromotors, insbesondere des Motorstroms des Elektromotors, verwendet wird.

12. Verfahren nach einem der Ansprüche 9-11, **dadurch gekennzeichnet, dass**
dem N-Bit-breiten Datenstrom das Ausgangssignal eines Quantisierumsetzers aufaddiert wird und das so entstandene Summensignal integriert wird und das Ergebnis dieser Integration einem
Quantisierer (74) zugeführt wird, dessen, insbesondere 1-Bit breites, Ausgangssignal einen ersten Wert, insbesondere HIGH aufweist, wenn das Eingangssignal des Quantisierers (74) einen oberen Schwellwert überschreitet, und erst dann einen zweiten Wert, insbesondere LOW aufweist, wenn das Eingangssignal des Quantisierers (74) einen unteren Schwellwert unterschreitet,
wobei das Ausgangssignal des Quantisierers (74) nicht nur das Ausgangssignal (76) des digitalen Modulators (60) bildet, sondern auch dem Quantisierumsetzer zugeführt wird,
dessen Ausgangssignal abhängig vom jeweils aktuellen Wert des Ausgangssignals des Quantisierers (74) den oberen oder den unteren Schwellwert als N-Bit breites Datensignal ausgibt, insbesondere dessen Ausgangssignal abhängig vom jeweils aktuellen Wert des Ausgangssignals des Quantisierers (74) den oberen oder den unteren Schwellwert als N-Bit breites Datensignal ausgibt und dieses Datensignal dem Summierer (70, 72) zugeführt wird.

13. Verfahren nach einem der Ansprüche 9-12, **dadurch gekennzeichnet, dass**
dem N-Bit-breiten Datenstrom das Ausgangssignal eines Quantisierumsetzers aufaddiert wird und das so entstandene Summensignal integriert wird und dem Ergebnis dieser Integration ebenfalls das Ausgangssignal eines Quantisierumsetzers aufaddiert wird und das so entstandene Summensignal integriert wird und das Ergebnis dieser Integration einem Quantisierer (74) zugeführt wird, dessen, insbesondere 1-Bit breites, Ausgangssignal einen ersten Wert, insbesondere HIGH aufweist, wenn das Eingangssignal des Quantisierers (74) einen oberen Schwellwert überschreitet, und erst dann einen zweiten Wert, insbesondere LOW aufweist, wenn das Eingangssignal des Quantisierers (74) einen unteren Schwellwert unterschreitet,
wobei das Ausgangssignal des Quantisierers (74) nicht nur das Ausgangssignal des digitalen Modulators (60) bildet, sondern auch dem Quantisierumsetzer zugeführt wird,
- dessen Ausgangssignal abhängig vom jeweils aktuellen Wert des Ausgangssignals des Quantisierers (74) den oberen oder den unteren Schwellwert als N-Bit breites Datensignal ausgibt,
- insbesondere dessen Ausgangssignal abhängig vom jeweils aktuellen Wert des Ausgangssignals des Quantisierers (74) den oberen oder den unteren Schwellwert als N-Bit breites Datensignal ausgibt und dieses Datensignal dem Summierer (70, 72) zugeführt wird.

## Claims

1. Drive comprising an electric motor that can be fed by an inverter (1),
wherein the electric motor is connected to the AC voltage-side terminal of the inverter (1) by means of feed lines,
in particular wherein each feed line is led to a respective motor phase terminal of the electric motor, which is configured in a three-phase or multi-phase manner,
wherein current sensors (20) for detecting the current in one of the feed lines are wired in parallel,
wherein each of the current sensors (20) in each case has a printed circuit board (33), each of which is equipped with a respective resistor, in particular in SMD technology, that acts as a shunt resistor,
wherein a first terminal of each resistor is electrically connected, in particular screw-connected, to a respective first busbar part (32), wherein a second terminal of each resistor is electrically connected, in particular screw-connected, to a respective second busbar part (34),
wherein the first busbar parts (32) are electrically interconnected and/or configured so as to be integral with one another,
wherein the second busbar parts (34) are electrically interconnected and/or configured so as to be integral with one another,
wherein
the number of current sensors (20) is N, where N is a natural number that is greater than one,
**characterised in that**
the N output signals of the current sensors (20) are added together by means of a summing means (50), and the result of this addition forms an N-bit-wide data stream that is supplied to an input, in particular an N-bit-wide input, of a digital modulator,
in particular wherein the digital modulator (60) is configured as a digitally configured low-pass filter, in particular of the second order,
or **in that**
the N output signals of the current sensors (20) form an N-bit-wide data stream that is supplied to an input, in particular an N-bit-wide input, of a digital modulator,
in particular wherein each individual output signal forms a particular site, in particular therefore a particular bit position, of the N-bit-wide data stream,
in particular wherein the digital modulator (60) is configured as a digitally configured low-pass filter, in particular of the second order.

2. Drive according to claim 1,
**characterised in that**
the first and the second busbar part (32, 34) are each arranged on the side of the printed circuit board (33) facing away from the resistor.

3. Drive according to any of the preceding claims,
**characterised in that**
the printed circuit board (33) rests on and/or is solder-connected to the first busbar part (32) by a first conducting track,
the printed circuit board (33) rests on and/or is solder-connected to the second busbar part (34) by a second conducting track.

4. Drive according to any of the preceding claims,
**characterised in that**
the voltage dropping at each resistor is supplied to a respective delta-sigma converter (40) of each current sensor (20), wherein each delta-sigma converter (40) makes available, at its output, a digital, in particular 1-bit-wide, data stream as the output signal,
in particular wherein the component(s) of the delta-sigma converter (40) of each current sensor (20) is/are arranged and/or fitted on the printed circuit board (33) of the particular current sensor (20).

5. Drive according to any of the preceding claims,
**characterised in that**
the digital modulator (60) comprises at least one summer (70, 72), to which the N-bit-wide data stream is supplied and the output signal of which is supplied to an integrator (71), wherein the digital modulator (60) comprises a quantizer (74) for processing the output signal of the integrator (71), the in particular 1-bit-wide output signal of which has a first value, in particular HIGH, when the input signal of the quantizer (74) exceeds an upper threshold value, and has a second value, in particular LOW, only when the input signal of the quantizer (74) drops below a lower threshold value,
wherein the output signal of the quantizer (74) not only constitutes the output signal (76) of the digital modulator but also is supplied to a quantizing converter, the output signal of which issues the upper or the lower threshold value as an N-bit-wide data signal depending on the particular current value of the output signal of the quantizer (74), and said data signal is supplied to the summer (70, 72).

6. Drive according to any of the preceding claims,
**characterised in that**
the N-bit-wide data stream is supplied to a summer (70, 72), the output signal of which is supplied to a first integrator (71),
wherein the output signal of the first integrator (71) is supplied to a second summer (70, 72), the output signal of which is supplied to a second integrator (73),
wherein the output signal of the second integrator (73) is supplied to a quantizer (74), the in particular 1-bit-wide output signal of which has a first value, in particular HIGH, when the output signal of the second integrator (73) exceeds an upper threshold value, and has a second value, in particular LOW, only when the output signal of the second integrator (73), i.e. the input signal of the quantizer (74), drops below a lower threshold value,
wherein the output signal of the quantizer (74) not only constitutes the output signal (76) of the digital modulator but also is supplied to a quantizing converter, the output signal of which issues the upper or the lower threshold value as an N-bit-wide data signal depending on the particular current value of the output signal of the quantizer (74), and said data signal is supplied to the first and also the second summer (70, 72),
in particular wherein the first summer (70, 72) generates, as the output signal, the sum of the data signal and the N-bit-wide data stream, and wherein the second summer (70, 72) generates, as the output signal, the sum of the data signal and the output signal of the first integrator (71).

7. Drive according to any of the preceding claims,
**characterised in that**
the summers (70, 72), the summing means (50), the integrators (71, 73), the quantizer and the quantizing converter, the delta-sigma converters (40) and/or the processing unit (42) are implemented in a single FPGA.

8. Drive according to any of the preceding claims,
**characterised in that**
the signals of two current sensors (20) wired in parallel are monitored for exceeding a permitted degree of deviation.

9. Method for operating a drive according to any of the preceding claims,
wherein the current in one motor phase feed line of an electric motor of the drive is detected by a number N of current sensors (20) being provided, in particular wired, in parallel, **characterised in that**
- either the N digitally represented, 1-bit-wide signals of the current sensors (20) are supplied as an N-bit-wide data stream to the input, in particular the N-bit-wide input, of a digital modulator of the drive,
in particular wherein each individual output signal of the particular current sensor (20) forms a particular site, in particular therefore a particular bit position, of the N-bit-wide data stream,
- or the N digitally represented, 1-bit-wide signals of the current sensors (20) are added together and the result of the addition is supplied as an N-bit-wide data stream to the input, in particular the N-bit-wide input, of a digital modulator of the drive,
in particular wherein the digital modulator (60) has low-pass characteristics, in particular of the second order,
in particular wherein the output signal (76) of the digital modulator is a 1-bit-wide data stream.

10. Method according to claim 9,
**characterised in that**
the current sensors (20) each comprise a shunt resistor, and the voltage dropping at the shunt resistor is detected and converted by a delta-sigma converter (40) into the digital 1-bit-wide signal of the particular current sensor (20).

11. Method according to any of claims 9 or 10,
**characterised in that**
the output signal (76) of the digital modulator is used as the actual value of the current in order to control the electric motor, in particular the motor current of the electric motor.

12. Method according to any of claims 9 to 11,
**characterised in that**
the output signal of a quantizing converter is added to the N-bit-wide data stream and the resulting summation signal is integrated, and the result of this integration is supplied to a quantizer (74), the in particular 1-bit-wide output signal of which has a first value, in particular HIGH, when the input signal of the quantizer (74) exceeds an upper threshold value, and has a second value, in particular LOW, only when the input signal of the quantizer (74) drops below a lower threshold value,
wherein the output signal of the quantizer (74) not only constitutes the output signal (76) of the digital modulator (60) but also is supplied to the quantizing converter, the output signal of which issues the upper or lower threshold value as an N-bit-wide data signal depending on the particular current value of the output signal of the quantizer (74), and the output signal of which in particular issues the upper or the lower threshold value as an N-bit-wide data signal depending on the particular current value of the output signal of the quantizer (74), and said data signal is supplied to the summer (70, 72).

13. Method according to any of claims 9 to 12,
**characterised in that**
the output signal of a quantizing converter is added to the N-bit-wide data stream and the resulting summation signal is integrated, and the output signal of a quantizing converter is likewise added to the result of said integration and the resulting summation signal is integrated, and the result of this integration is supplied to a quantizer (74), the in particular 1-bit-wide output signal of which has a first value, in particular HIGH, when the input signal of the quantizer (74) exceeds an upper threshold value, and has a second value, in particular LOW, only when the input signal of the quantizer (74) drops below a lower threshold value, wherein the output signal of a quantizer (74) not only constitutes the output signal of the digital modulator (60) but also is supplied to the quantizing converter,
- the output signal of which issues the upper or the lower threshold value as an N-bit-wide data signal depending on the particular current value of the output signal of the quantizer (74),
- and the output signal of which in particular issues the upper or the lower threshold value as an N-bit-wide data signal depending on the particular current value of the output signal of the quantizer (74), and said data signal is supplied to the summer (70, 72).

## Revendications

1. Entraînement comprenant un moteur électrique pouvant être alimenté par un onduleur (1), le moteur électrique étant relié au raccord, situé côté tension alternative, de l'onduleur (1) au moyen de lignes d'alimentation,
une ligne d'alimentation respective étant en particulier guidée vers un raccord de phase de moteur respectif du moteur électrique triphasé ou polyphasé,
des capteurs de courant permettant de détecter le courant dans l'une des lignes d'alimentation étant montés en parallèle,
chacun des capteurs de courant (20) présentant respectivement une carte de circuit imprimé (33) respectivement munie d'une résistance agissant respectivement comme un shunt résistif, en particulier selon la technologie CMS,
un premier raccord de la résistance étant respectivement relié électriquement, en particulier de manière vissée, à une première section de rail conducteur (32) respective,
un second raccord de la résistance étant respectivement relié électriquement, en particulier de manière vissée, à une seconde section de rail conducteur (34) respectif, les premières sections de rail conducteur (32) étant reliées électriquement les unes aux autres et/ou étant réalisées ensemble d'un seul tenant,
les secondes sections de rail conducteur (34) étant reliées électriquement les unes aux autres et/ou étant réalisées ensemble d'un seul tenant,
- le nombre de capteurs de courant (20) étant égal à N, N étant un nombre naturel supérieur à un,
**caractérisé en ce que**
les N signaux de sortie des capteurs de courant (20) sont additionnés au moyen d'un moyen de sommation (50) et le résultat de ladite addition forme un flux de données de largeur N bits qui est acheminé vers une entrée, en particulier une entrée de largeur N bits, d'un modulateur numérique,
le modulateur numérique (60) étant en particulier réalisé sous forme de filtre passe-bas numérique, en particulier du second ordre,
ou **en ce que**
les N signaux de sortie des capteurs de courant (20) forment un flux de données de largeur Nbits qui est acheminé vers une entrée, en particulier une entrée de largeur N bits, d'un modulateur numérique,
chaque signal de sortie individuel formant en particulier un emplacement respectif, en particulier une position de bit respective, du flux de données de largeur N bits,
le modulateur numérique (60) étant en particulier réalisé sous forme de filtre passe-bas numérique, en particulier du second ordre.

2. Entraînement selon la revendication 1,
**caractérisé en ce que**
les première et seconde sections de rail conducteur (32, 34) sont agencées respectivement sur le côté de la carte de circuit imprimé (33) opposé à la résistance.

3. Entraînement selon l'une quelconque des revendications précédentes,
**caractérisé en ce que**
une première piste conductrice de la carte de circuit imprimé (33) repose et/ou est soudée sur la première section de rail conducteur (32),
une seconde piste conductrice de la carte de circuit imprimé (33) repose et/ou est soudée sur la seconde section de rail conducteur (34).

4. Entraînement selon l'une quelconque des revendications précédentes,
**caractérisé en ce que**
la tension qui chute au niveau de la résistance est respectivement acheminée vers un convertisseur delta-sigma (40) respectif du capteur de courant (20) respectif, le convertisseur delta-sigma (40) respectif fournissant au niveau de sa sortie un flux de données numérique, en particulier de largeur 1 bit, faisant office de signal de sortie, en particulier, le ou les composant(s) du convertisseur delta-sigma (40) du capteur de courant (20) respectif étant agencé(s) sur, et/ou équipant, la carte de circuit imprimé (33) du capteur de courant (20) respectif.

5. Entraînement selon l'une quelconque des revendications précédentes, **caractérisé en ce que**
le modulateur numérique (60) présente au moins un sommateur (70, 72) vers lequel est acheminé le flux de données de largeur N bits et dont le signal de sortie est acheminé vers un intégrateur (71),
le modulateur numérique (60) présente un quantificateur (74) permettant de traiter le signal de sortie de l'intégrateur (71), dont le signal de sortie, en particulier d'une largeur de 1 bit, présente une première valeur, en particulier HAUTE, lorsque le signal d'entrée du quantificateur (74) dépasse une valeur de seuil supérieure, et ne présente une seconde valeur, en particulier BASSE, que lorsque le signal d'entrée du quantificateur (74) devient inférieur à une valeur de seuil inférieure,
le signal de sortie du quantificateur (74) formant non seulement le signal de sortie (76) du modulateur numérique, mais étant également acheminé vers un convertisseur de quantification, dont le signal de sortie émet la valeur de seuil supérieure ou inférieure sous forme de signal de données de largeur N bits en fonction de la valeur actuelle respective du signal de sortie du quantificateur (74) et ledit signal de données est acheminé vers le sommateur (70, 72).

6. Entraînement selon l'une quelconque des revendications précédentes, **caractérisé en ce que**
le flux de données de largeur N bits est acheminé vers un sommateur (70, 72) dont le signal de sortie est acheminé vers un premier intégrateur (71),
le signal de sortie du premier intégrateur (71) étant acheminé vers un second sommateur (70, 72) dont le signal de sortie est acheminé vers un second intégrateur (73),
le signal de sortie du second intégrateur (73) étant acheminé vers un quantificateur (74) dont le signal de sortie, en particulier d'une largeur de 1 bit, présente une première valeur, en particulier HAUTE, lorsque le signal de sortie du second intégrateur (73) dépasse une valeur de seuil supérieure, et ne présente une seconde valeur, en particulier BASSE, que lorsque le signal de sortie du second intégrateur (73), c'est-à-dire le signal d'entrée du quantificateur (74), est inférieur à une valeur de seuil inférieure,
le signal de sortie du quantificateur (74) formant non seulement le signal de sortie (76) du modulateur numérique, mais étant également acheminé vers un convertisseur de quantification, dont le signal de sortie émet la valeur de seuil supérieure ou inférieure sous forme de signal de données de largeur N bits en fonction de la valeur actuelle respective du signal de sortie du quantificateur (74) et ledit signal de données est acheminé vers les premier et également second sommateurs (70, 72),
le premier sommateur (70, 72) formant en particulier un signal de données à partir de la somme du signal de données et du flux de données de largeur N bits et le second sommateur (70, 72) formant en particulier un signal de sortie à partir de la somme du signal de données et du signal de sortie du premier intégrateur (71).

7. Entraînement selon l'une quelconque des revendications précédentes, **caractérisé en ce que**
les sommateurs (70, 72), le moyen de sommation (50), les intégrateurs (71, 73), le quantificateur et le convertisseur de quantification, les convertisseurs delta-sigma (40) et/ou l'unité de traitement (42) sont mis en oeuvre au sein d'un unique FPGA.

8. Entraînement selon l'une quelconque des revendications précédentes, **caractérisé en ce que**
le dépassement d'une quantité admissible de déviation est surveillé chez les signaux de deux capteurs de courant (20) connectés en parallèle.

9. Procédé de fonctionnement d'un entraînement selon l'une quelconque des revendications précédentes,
le courant étant détecté dans une ligne d'alimentation de phase de moteur d'un moteur électrique de l'entraînement grâce à la fourniture, en particulier grâce à la connexion, d'un nombre N de capteurs de courant (20) en parallèle,
**caractérisé en ce que**
- soit les N signaux, représentés de manière numérique, de largeur 1 bit des capteurs de courant (20) sont acheminés sous forme de flux de données de largeur N bits vers l'entrée, en particulier l'entrée de largeur N bits, d'un modulateur numérique de l'entraînement,
chaque signal de sortie individuel du capteur de courant (20) respectif formant en particulier un emplacement respectif, en particulier une position de bit respective, du flux de données de largeur N bits,
- soit les N signaux, représentés de manière numérique, de largeur 1 bit des capteurs de courant (20) sont additionnés et le résultat de l'addition est acheminé sous forme de flux de données de largeur N bits vers l'entrée, en particulier vers l'entrée de largeur N bits, d'un modulateur numérique de l'entraînement,
le modulateur numérique (60) présentant en particulier un comportement de filtre passe-bas, en particulier du second ordre,
le signal de sortie (76) du modulateur numérique étant en particulier un flux de données de largeur 1 bit.

10. Procédé selon la revendication 9,
**caractérisé en ce que**
les capteurs de courant (20) présentent respectivement une résistance de shunt et détecte la tension qui chute au niveau de la résistance de shunt et sont converti par un convertisseur delta-sigma (40) en signal numérique de largeur 1 bit du capteur de courant (20) respectif.

11. Entraînement selon l'une quelconque des revendications 9 ou 10,
**caractérisé en ce que**
le signal de sortie (76) du modulateur numérique est utilisé comme valeur actuelle de courant pour réguler le moteur électrique, en particulier le courant de moteur du moteur électrique.

12. Procédé selon l'une quelconque des revendications 9 à 11,
**caractérisé en ce que**
le signal de sortie d'un convertisseur de quantification est ajouté au flux de données de largeur N bits et le signal de somme ainsi obtenu est intégré et le résultat de ladite intégration est acheminé vers un quantificateur (74) dont le signal de sortie, en particulier de largeur 1 bit, présente une première valeur, en particulier HAUTE, lorsque le signal d'entrée du quantificateur (74) dépasse une valeur de seuil supérieure, et ne présente une seconde valeur, en particulier BASSE, que lorsque le signal d'entrée du quantificateur (74) devient inférieur à une valeur de seuil inférieure, le signal de sortie du quantificateur (74) formant non seulement le signal de sortie (76) du modulateur numérique (60), mais étant également acheminé vers le convertisseur de quantification dont le signal de sortie émet la valeur de seuil supérieure ou inférieure sous forme de signal de données de largeur N bits en fonction de la valeur actuelle respective du signal de sortie du quantificateur (74), en particulier dont le signal de sortie émet la valeur de seuil supérieure ou inférieure sous forme de signal de données de largeur N bits en fonction de la valeur actuelle respective du signal de sortie du quantificateur (74) et ledit signal de données est acheminé vers le sommateur (70, 72).

13. Procédé selon l'une quelconque des revendications 9 à 12,
**caractérisé en ce que**
le signal de sortie d'un convertisseur de quantification est ajouté au flux de données de largeur N bits et le signal de somme ainsi obtenu est intégré et le signal de sortie d'un convertisseur de quantification est également ajouté au résultat de ladite intégration et le signal de somme ainsi obtenu est intégré et le résultat de ladite intégration est acheminé vers un quantificateur (74) dont le signal de sortie, en particulier de largeur 1 bit, présente une première valeur, en particulier HAUTE, lorsque le signal d'entrée du quantificateur (74) dépasse une valeur de seuil supérieure, et ne présente une seconde valeur, en particulier BASSE, que lorsque le signal d'entrée du quantificateur (74) devient inférieur à une valeur de seuil inférieure, le signal de sortie du quantificateur (74) formant non seulement le signal de sortie du modulateur numérique (60), mais étant également acheminé vers le convertisseur de quantification,
- dont le signal de sortie émet la valeur de seuil supérieure ou inférieure sous forme de signal de données de largeur N bits en fonction de la valeur actuelle respective du signal de sortie du quantificateur (74),
- en particulier dont le signal de sortie émet la valeur de seuil supérieure ou inférieure sous forme de signal de données de largeur N bits en fonction de la valeur actuelle respective du signal de sortie du quantificateur (74) et ledit signal de données est acheminé vers le sommateur (70, 72).
